# EUROPEAN PATENT SPECIFICATION

(11) **EP 3 736 356 B1**
(45) Date of publication and mention of the grant of the patent: **28.06.2023**
(21) Application number: 19888257.3
(22) Date of filing: 05.09.2019
(51) Int. Cl.: C23C 14/34, B23K 20/00, H01L 21/285, C23C 14/06, C23C 14/14, C23C 14/18, H01J 37/34

(54) **JOINED BODY OF TARGET MATERIAL AND BACKING PLATE, AND METHOD FOR MANUFACTURING JOINED BODY OF TARGET MATERIAL AND BACKING PLATE**
VERBUNDKÖRPER AUS ZIELMATERIAL UND TRÄGERPLATTE SOWIE VERFAHREN ZUR HERSTELLUNG EINES GELENKKÖRPERS AUS ZIELMATERIAL UND TRÄGERPLATTE
ENSEMBLE JOINT D'UNE CIBLE ET D'UNE PLAQUE DE SUPPORT, ET PROCÉDÉ PERMETTANT DE FABRIQUER UN ENSEMBLE JOINT D'UNE CIBLE ET D'UNE PLAQUE DE SUPPORT

(30) Priority: 28.03.2019 JP 2019064757
(43) Date of publication of application: 11.11.2020
(73) Proprietor: JX Nippon Mining & Metals Corporation, Tokyo 100-8164 (JP)
(72) Inventor: NAGATSU, Kotaro, Ibaraki 3191535 (JP); YAMADA, Yuki, Ibaraki 3191535 (JP)
(74) Representative: Mewburn Ellis LLP
(86) International application number: PCT/JP2019/035045
(87) International publication number: WO 2020/194789

(56) References cited:
- EP-A1- 0 902 102
- WO-A1-2012/014921
- JP-A- H 111 766
- JP-A- H1 180 942
- JP-A- H01 290 766
- JP-A- 2001 342 506
- JP-A- 2016 191 103

## Description

### TECHNICAL FIELD

The specification discloses a technique relating to a joined body of a target material and a backing plate, and a method for producing a joined body of a target material and a backing plate.

### BACKGROUND ART

For example, in production of Cu wiring in a semiconductor device, a diffusion barrier layer containing Ta/TaN for preventing Cu diffusion may be formed in a contact hole or a recessed portion of a wiring groove, and a Cu base layer and an electrolytic plating layer of Cu may be sequentially formed on the diffusion barrier layer.

Such a diffusion barrier layer is generally formed by producing a thin film containing Ta by means of sputtering using a target material containing Ta.

Examples of such a kind of target material containing Ta include those described in Patent Documents 1 and 2.

Patent Document 1 discloses:
"a sputtering target, wherein (a) an average crystal grain diameter is from 0.1 to 300 µm, a variation in the average crystal grain diameter depending on positions is ± 20% or less, (b) an oxygen concentration is 50 ppm or less, (c) an impurity concentration is Na ≤ 0.1 ppm, K ≤ 0.1 ppm, U ≤ 1 ppb, Th ≤ 1 ppb, Fe ≤ 5 ppm, Cr ≤ 5 ppm, Ni ≤ 5 ppm, and a total of contents of high melting point metal elements (Hf, Nb, Mo, W, Ti and Zr) is 50 ppm or less". Further, Patent Document 1 discloses that "when hydrogen atoms are contained in the Ta film, a film stress of the Ta film increases, so that the Ta/TaN film is easily peeled off from a component and a side wall in a sputtering apparatus, causing an increase in the number of particles on a wafer, and also that the present inventors have found that when the hydrogen concentration in the target is 20 ppm or less, the number of particles can be reduced to a level at which there is no practical problem".

Patent document 2 focuses on "a problem that a degree of vacuum in a vacuum chamber does not increase when sputtering is carried out using a target", and mentions its causes:
"a higher hydrogen partial pressure in the vacuum chamber", "a large amount of hydrogen is stored on the surface of the target to be used, and the hydrogen is vaporized during sputtering, so that the hydrogen partial pressure in the chamber is increased", and the like.

To solve the problems as described above, Patent Document 2 proposes "a sputtering target and/or a coil disposed at the periphery of a plasma-generating region for confining plasma, the target and/or the coil having a surface to be eroded with a hydrogen content of 500 µL/cm² or less", and "a method of producing a sputtering target and/or a coil, comprising; heating a sputtering target and/or a coil disposed at the periphery of a plasma-generating region for confining plasma under a vacuum atmosphere or an inert gas atmosphere to regulate the hydrogen content of a surface to be eroded of the target and/or the coil to 500 µL/cm² or less".

Patent Document 3 proposes "a method for producing a sputtering target, comprising subjecting a target processing surface to a heat treatment using a local heating radiation source in vacuum in finish processing of the sputtering target". It also discloses that according to the method, "a processed modified layer (cutting strain) of the target surface layer can be sufficiently reduced, and hydrogen adsorbed or stored on the target surface can be removed", and "the target with reduced processed modified layer and reduced hydrogen adsorption can suppress the generation of particles at the initial stage of sputtering and shorten the burn-in time". In Patent Document 3, the "sputtering target" is intended to be "composed of at least one metal selected from the group consisting of Cu, Ti, Ta, Al, Ni, Co, W, Si, Pt, and Mn".

### CITATION LIST

### Patent Literatures

Patent Document 1: Japanese Patent Application Publication No. H11-80942 A corresponding to EP0902102 A1
Patent Document 2: WO 2012/014921 A1
Patent Document 3: Japanese Patent Application Publication No. 2016-191103 A

### SUMMARY OF INVENTION

### Technical Problem

The target material as described above is generally joined to a backing plate having functions such as cooling of the target material and electrodes, and is subjected to sputtering as a joined body of the target material and the backing plate.

If the hydrogen content in the target material in the joined body of the target material and the backing plate is higher, there is a problem that the so-called burn-in period during sputtering becomes long. The burn-in period refers to a period that cannot be applied to the sputtering process, until the target surface is used to some extent during sputtering to settle the sputtering performance of the target material.

Here, a new finding has been obtained that the hydrogen content in the target material in the above joined body can increase when the target material is joined to the backing plate.

It cannot be said that Patent Documents 1 to 3 have sufficiently studied the hydrogen content in the target material after joining it to the backing plate, and it can be said that there is room for further reduction in the hydrogen content after joining. In fact, Patent Documents 1 and 2 measure the hydrogen content in the target material before joining it to the backing plate, based on descriptions of each of Examples, and would focus on the hydrogen content before joining. Therefore, in Patent Documents 1 and 2, it is undeniable that the target material after joining it to the backing plate may increase the hydrogen content, thereby prolonging the burn-in period. In Patent Document 3, the hydrogen content in the target material may be relatively high.

This specification discloses a joined body of a target material and a backing plate, which can effectively reduce a hydrogen content in the target material while joining the target material to the backing plate with a required strength, and a method for producing a joined body of a target material and a backing plate.

### Solution to Problem

A joined body of a target material and a backing plate disclosed in this specification comprises a target material containing Ta and a backing plate joined to the target material, wherein a tensile strength between the target material and the backing plate is 196.133 MPa (20kgf/mm²) or more, and the target material joined to the backing plate has an average hydrogen content of 7 ppm by volume or less.

A method for producing a joined body of a target material and a backing plate disclosed in this specification comprises the steps of: preparing each of a target material containing Ta and a backing plate; and joining the target material to the backing plate by overlapping the target material and the backing plate with each other and pressing them while heating them in an inert gas atmosphere, wherein in the step of joining the target material to the backing plate, a hydrogen concentration in the inert gas atmosphere is 5 ppm by volume or less, and the target material and the backing plate overlapped with each other are heated at a temperature of from 600 °C to 800 °C.

### Advantageous Effects of Invention

According to the joined body of the target material and the backing plate and the method for producing the joined body of the target material and the backing plate as described above, the hydrogen content in the target material can be effectively reduced while joining the target material to the backing plate with a required strength.

### BRIEF DESCRIPTION OF DRAWINGS

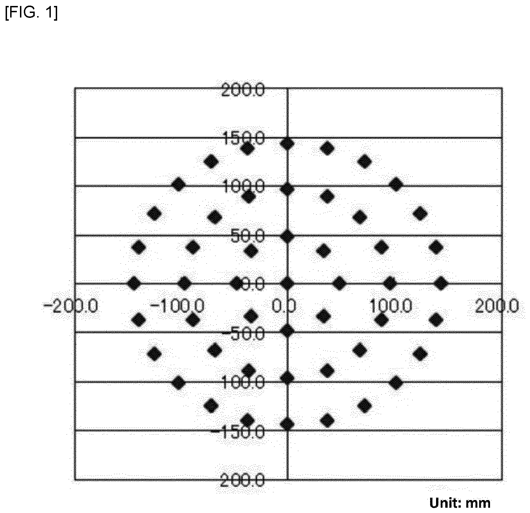

FIG. 1 is a schematic view showing 49 points for measuring sheet resistance of a wafer when calculating a resputtering rate.

### DESCRIPTION OF THE PREFERRED EMBODIMENTS

Hereinafter, embodiments disclosed in this specification will be described in detail. A joined body of a target material and a backing plate according to an embodiment (hereinafter, also simply referred to as a "joined body") includes a target material containing Ta and a backing plate joined to the target material, wherein a tensile strength between the target material and the backing plate is 196.133 MPa (20kgf/mm²) or more, and the target material has an average hydrogen content of 7 ppm by volume or less.

### (Target Material)

The target material mainly contains Ta, and has a content of Ta of preferably 99.99% by mass (4N) or more, and more preferably 99.999% by mass (5N) or more. Such a target material containing Ta with high purity is particularly suitable for forming a diffusion barrier layer containing Ta/TaN during production of Cu wiring. The content of Ta in the target material may be, for example, 99.9999% by mass (6N) or less.

The target material may contain at least one selected from the group consisting of Nb, W, and Mo as an impurity element other than Ta. If the target material contains such an impurity element, the total content of the impurity element in the target material is preferably 0.01% by mass or less, and more preferably 0.001% by mass or less.

The target material generally has a flat plate shape, especially a disk shape. The surface of the target material is used as a target surface by sputtering, while the back surface of the target material will be a joining surface to be joined to a backing plate as described later.

### (Backing Plate)

The backing plate to be joined to the joining surface of the target material generally has a substantially flat plate shape, especially a disk shape, substantially similar to the target material.

This backing plate can be made of various materials. Preferably, it may be made of a Cu-Zn alloy containing Cu and Zn. This is because the backing plate made of the Cu-Zn alloy can exhibit high strength, improved cooling performance or other required performance. In addition, the backing plate may be made of, for example, Al or an Al alloy or a Cu-Cr alloy (such as C18000).

When the backing plate contains Cu and Zn, the content of Cu in the backing plate is preferably from 60% by mass to 70% by mass, and the content of Zn is preferably from 30% by mass to 40% by mass. The backing plate containing Cu and Zn may further contain 0.5% by mass to 1.5% by mass of Sn.

### (Hydrogen Content)

In the joined body of the target material and the backing plate as described above, the hydrogen content in the target material tends to increase after joining, mainly due to storage of hydrogen in the target material during joining, and the like, although details will be described later.

In contrast, according to the embodiment described herein, the hydrogen content in the target material in the joined body can be effectively reduced.

Specifically, an average hydrogen content in the target material in the joined body is 7 ppm by volume or less, and preferably 5 ppm by volume or less. If the average hydrogen content in the target material is more than 7 ppm by volume, hydrogen is discharged into a chamber of a sputtering apparatus, so that a resputtering rate as described below decreases. As a result, the burn-in period from the start of sputtering to the stabilization of performance becomes longer. In this case, the productivity of the Cu wiring and the like are reduced and the production cost is increased, as well as the amount or time in which the target material can be substantially used for sputtering is reduced.

From such a viewpoint, the average hydrogen content in the target material in the joined body is preferably 7 ppm by volume or less, and more preferably 5 ppm by volume or less. It is desirable that the average hydrogen content is as low as possible, but it may be, for example, 1 ppm by volume or more, typically 2 ppm by volume or more.

For calculation of the average hydrogen content in the target material, samples (2 to 10 g) are cut out from the target material forming the joined body at each of a target surface position and a central position in a thickness direction of the target material in an outer peripheral portion of the target material. Each sample is then heated and gasified, and then measured for a hydrogen content of each sample using an infrared absorption method (EMGA-930 from Horiba, Ltd.). An average value of the hydrogen content of each sample is then determined, which is defined as the average hydrogen content as described above.

Further, a difference between the hydrogen content at the target surface position of the target material and the hydrogen content at the central position in the thickness direction of the target material in the outer peripheral portion of the target material in the form of disk or the like is more particularly 2 ppm by volume or less. Further, the difference between the hydrogen content at the target surface position and the hydrogen content at the central position in the thickness direction is more preferably 1 ppm by volume or less. If the difference is larger, the hydrogen content will be higher at either the target surface position or the central position in the thickness direction, which may lead to a lower resputtering rate.

It should be noted that the difference between the hydrogen contents is determined as a difference between the respective hydrogen contents obtained by cutting out the respective samples from the target material forming the joined body, as described above.

### (Resputtering Rate)

The target material forming the joined body preferably has a resputtering rate of 5.2 or more and 6.5 or less at a life of 75 kWhr when used for sputtering. This can allow the period to stabilization of the resputtering rate to be shortened when the joined body is used for sputtering. Accordingly, the burn-in period from the time when the joined body is used for sputtering to the time when the sputtering performance of the target material is stabilized is shortened. That is, the sputtering performance is stabilized at an early stage. In this case, a variation in the resputtering rate for the life of the target material from 15 kWhr to 250 kWhr may be 0.7 or less.

If the resputtering rate is less than 5.2 or more than 6.5, uniformity of a film thickness during the period to stabilization of the resputtering rate may be deteriorated.

The resputtering rate of the target material is more preferably 5.5 or more and 6.0 or less.

The resputtering rate is an index for confirming whether re-sputtering (so-called resputtering) from a thin film during sputtering is properly performed, and it is considered that the resputtering rate can be changed depending on hydrogen in the chamber.

The resputtering rate is obtained by measuring sheet resistance Rs at 49 points of the wafer as illustrated in FIG. 1. Specifically, for a wafer A formed by a recipe called a base recipe and a wafer B formed by a recipe called a base recipe → a resputter recipe by a magnetron sputtering apparatus, a difference between film thicknesses of the wafers A and B converted from the sheet resistance Rs is calculated at each of 49 points, and a value obtained by dividing an average value of the film thickness differences at 49 points by a film forming time of 15 seconds in the resputtering recipe can be determined to be the resputtering rate. The base recipe is under the following conditions: power supply of DC; a power of 25 kW; a wafer bias of 400 W; a film formation time of 25 sec; and the resputtering recipe is under the conditions: power supply of DC; a power of 0.5 kW; a wafer bias of 1 kW; a film formation time of 15 seconds. The size of the wafer can be 12 inches.

In order to bring about the resputtering rate of the target material within the predetermined range as described above, it is possible to adjust the average hydrogen content in the target material, the difference between the hydrogen content at the target surface position and the hydrogen content at the central position in the thickness direction, and the like, as described above. In particular, the resputtering rate may significantly depend on the average hydrogen content in the target material.

### (Tensile Strength)

In the joined body, the target material and the backing plate must be joined with a required strength. A tensile strength between the target material and the backing plate in the joined body is preferably 196.133 MPa (20kgf/mm²) or more. The tensile strength is more preferably from 196.133 MPa (20kgf/mm²) to 294.200 MPa (30kgf/mm²).

If the tensile strength is less than 196.133 MPa (20kgf/mm²), the target material and the backing plate may be detached at the joined interface during sputtering. It should be noted that the tensile strength may be typically 294.200 MPa (30kgf/mm²) or less. In addition, such a predetermined joining strength between the target material and the backing plate can be achieved by setting a predetermined temperature and pressure when joining the target material and the backing plate, as described later.

The tensile strength between the target material and the backing plate is measured using an Autograph AG-25TA from Shimadzu Corporation at a test rate of 0.5 mm/min, and a stress at the time of fracture of the joined surface between the target material and the backing plate is defined as the tensile strength which is an average value of measured values of samples taken from one position at the center, one position at half of the radius, and one position at the outer peripheral portion in the joined portion between the target material and the backing plate.

### (Production Method)

The joined body of the target material and the backing plate as described above can be produced, for example, as follows:
Here, at least the following steps are carried out: a step of preparing each of a target material containing Ta and a backing plate made of a Cu-Zn alloy or the like; and a step of joining the target material and the backing plate overlapped with each other by pressing them while heating them an inert gas atmosphere.

To produce the target material containing Ta in the step of preparing the target material and the backing plate, for example, a certain tantalum raw material having high purity such as 4N (99.99% by mass) or more is melted by an electron beam melting method and casted to obtain an ingot or billet containing Ta. By using the electron beam melting method, a high-purity ingot or billet can be obtained, but other melting method may be used.

Subsequently, the above ingot or billet is cut into a predetermined size and shape as required, and subjected to forging, rolling, a heat treatment, and machining or the like before joining to the backing plate in this order. Here, the forging and rolling can destroy a cast structure to diffuse or eliminate pores and segregation. In the heat treatment after the forging and rolling, for example, heating is carried out in a vacuum atmosphere at a temperature of from about 800 °C to 1000 °C to promote recrystallization. By these treatments, the structure is densified and refined, and the strength is increased.

In the step of joining the target material and the backing plate, the target material and the backing plate are pressed while heating them in an inert gas atmosphere, thereby allowing them to be thermocompression-bonded by diffusion bonding.

At this time, it is important to sufficiently reduce the hydrogen concentration in the inert gas atmosphere to 5 ppm by volume or less. This is based on new findings that a small amount of hydrogen in an inert gas atmosphere during heating and pressing at the time of joining diffuses in the Ta-containing target material to occlude hydrogen to Ta, so that the target material forming the joined body causes the hydrogen content to be increased. It is assumed that such a hydrogen supply source is a trace amount of hydrogen that can be originally contained in the inert gas such as argon, or moisture brought from the outside.

The hydrogen concentration in the inert gas atmosphere of 5 ppm by volume or less can allow the hydrogen content in the target material forming the produced joined body to be effectively reduced. From this viewpoint, the hydrogen concentration in the inert gas atmosphere is preferably 5 ppm by volume or less, and more preferably 4 ppm by volume or less. The hydrogen concentration in the inert gas atmosphere may be, for example, 1 ppm by volume or more, typically 2 ppm by volume or more.

The hydrogen concentration in the inert gas atmosphere can be measured by gas chromatography.

The inert gas in the inert gas atmosphere can be an argon gas, helium, krypton, or the like. Among them, the argon gas is preferable in terms of productivity.

It is considered that an amount of hydrogen reaching the target material from the inert gas atmosphere may depend on the temperature and time during heating, in addition to the hydrogen concentration in the inert gas atmosphere.

Therefore, in the step of joining the target material and the backing plate, the target material and the backing plate overlapped with each other are preferably heated at a temperature of from 600 °C to 800 °C, and further preferably at a temperature of from 650 °C to 750 °C.

In terms of reducing the hydrogen content in the target material after joining, it is desirable to lower a joining temperature. However, when the heating temperature during joining is too low, an adhesion or joining strength between the target material and the backing plate may be reduced. If the heating temperature during joining is too high, the hydrogen content in the target material after joining may increase, and grain growth and recrystallization may occur, so that the sputtering performance of the target material may vary.

In the step of joining the target material and the backing plate, the target material and the backing plate overlapped with each other are pressed while being heated for preferably 1 hour to 5 hours, and more preferably 2 hours to 4 hours. In this case, there are advantages that a hydrogen storage amount is reduced and warpage is suppressed. If the times for heating and pressing are too long, the hydrogen storage amount may be excessive and warpage of the joined body may occur, and if the times are too short, joining may be insufficient.

In order to sufficiently reduce the hydrogen content to the inside of the target material in the joined body, it is desirable to adjust conditions of, in particular diffusion bonding, final heat treatment of the target material, and the like.

In the step of joining the target material and the backing plate, for example, a pressure of 1300 kgf/cm² to 1500 kgf/cm², preferably 1350 kgf/cm² to 1450 kgf/cm², can be applied to the target material and the backing plate overlapped with each other. If the pressure is too low, the adhesion or joining strength between the target material and the backing plate may be reduced. If the pressure is too high, there is a concern that the hydrogen storage amount is excessive and the material is deformed.

After the step of joining the target material and the backing plate, a finishing process, a surface treatment, and the like are carried out as needed. Accordingly, the joined body of the target material and the backing plate can be produced.

### (Tantalum Thin Film)

Using the above joined body of the target material and the backing plate, sputtering can be carried out on a substrate or the like with a sputtering apparatus to produce a tantalum thin film.

The tantalum thin film contains Ta and has substantially the same composition as that of the target material. More particularly, the Ta content in the tantalum thin film may be 99.99% by mass or more. The tantalum thin film may contain at least one impurity selected from the group consisting of Nb, Wand Mo in a total amount of 0.01% by mass or less.

Further, the tantalum thin film itself has an effectively reduced hydrogen content caused by forming the film using the target material having the lower hydrogen content. For example, a hydrogen content SIMS analysis intensity ratio (hydrogen content SIMS H/Ta secondary ion intensity ratio) contained per a unit volume of the tantalum thin film may be 3000 or less, or even 2500 or less. This can provide a high-quality tantalum thin film having a small film stress. It should be noted that the hydrogen content SIMS analysis intensity ratio of the tantalum thin film may be 2000 or more, and further 2500 or more. The hydrogen content SIMS analysis intensity ratio per a unit volume of the tantalum thin film is measured by carrying out SIMS analysis under conditions of a measuring device: PHI ADEPT1010; primary ion species: s⁺; primary acceleration voltage: 3.0 kV; detection area: 155 × 155 (µm × µm), on a 30-40 nm tantalum thin film formed on, for example a SiOz wafer.

### EXAMPLES

### (Example 1)

A tantalum raw material having a purity of 99.997% by mass was melted by electron beam and cast to produce an ingot having a diameter of 195 mm. The ingot was then forged by means of cold press forging so as to have a diameter of 150 mm, and then cut to a required length to obtain a billet.

This was then subjected to recrystallization annealing at a temperature of from 1100 to 1400 °C. Again, this was forged at room temperature so as to have a thickness of 100 mm and a diameter of 150 mm (primary forging), which was subjected to recrystallization annealing at a temperature of from recrystallization temperature to 1400 °C. Further, this was forged at room temperature so as to have a thickness of 70 to 100 mm and a diameter of 150 to 185 mm (secondary forging), which was subjected to recrystallization annealing at a temperature of from a recrystallization temperature to 1400 °C to obtain a target material. The resulting target material was subjected to cold rolling at a rolling rate of 15 m/min and a rolling ratio of from 80 to 90% using a rolling roll having a rolling roll diameter of 650 mm so as to have a thickness of 8 mm and a diameter of 500 mm, which was subjected to a heat treatment at a temperature of from 800 to 1000 °C. Subsequently, machining was carried out to produce a disk-shaped tantalum target material having a thickness of 8 mm and a diameter of 450 mm.

For a backing plate, a Cu alloy having 34% by mass of Zn, 0.8% by mass of Sn, the balance being Cu, was used to prepare a backing plate having a diameter of 540 mm and a thickness of 25 mm.

The target material and the backing plate were then pressed at a pressure of 1450 kgf/cm² while being heated in a Ar gas atmosphere containing 4 ppm by volume of hydrogen at 800 °C for 2 to 4 hours to thermocompression-bond them by diffusion bonding.

### (Example 2)

After producing the target material and the backing plate in the same method as that of Example 1, the target material and the backing plate were thermocompression-bonded by diffusion bonding in the same method as that of Example 1, with the exception that an Ar gas atmosphere containing 5 ppm by volume of hydrogen was used.

### (Example 3)

After producing the target material and the backing plate in the same method as that of Example 1, the target material and the backing plate were thermocompression-bonded by diffusion bonding in the same method as that of Example 1, with the exception that an Ar gas atmosphere containing 5 ppm by volume of hydrogen and a heating temperature of 750 °C were used.

### (Example 4)

After producing the target material and the backing plate in the same method as that of Example 1, the target material and the backing plate were thermocompression-bonded by diffusion bonding in the same method as that of Example 1, with the exception that a heating temperature of 750 °C was used.

### (Example 5)

After producing the target material and the backing plate in the same method as that of Example 1, the target material and the backing plate were thermocompression-bonded by diffusion bonding in the same method as that of Example 1, with the exception that a heating temperature of 650 °C was used.

### (Example 6)

After producing the target material and the backing plate in the same method as that of Example 1, the target material and the backing plate were thermocompression-bonded by diffusion bonding in the same method as that of Example 1, with the exception that an Ar gas atmosphere containing 5 ppm by volume of hydrogen and a heating temperature of 650 °C were used.

### (Example 7)

After producing the target material and the backing plate in the same method as that of Example 1, the target material and the backing plate were thermocompression-bonded by diffusion bonding in the same method as that of Example 1, with the exception that an Ar gas atmosphere containing 5 ppm by volume of hydrogen and a heating temperature of 600 °C were used.

### (Comparative Example 1)

After producing the target material and the backing plate in the same method as that of Example 1, the target material and the backing plate were thermocompression-bonded by diffusion bonding in the same method as that of Example 1, with the exception that a heating temperature of 500 °C was used.

### (Comparative Example 2)

After producing the target material and the backing plate in the same method as that of Example 1, the target material and the backing plate were thermocompression-bonded by diffusion bonding in the same method as that of Example 1, with the exception that an Ar gas atmosphere containing 30 ppm by volume of hydrogen was used.

### (Comparative Example 3)

After producing the target material and the backing plate in the same method as that of Example 1, the target material and the backing plate were thermocompression-bonded by diffusion bonding in the same method as that of Example 1, with the exception that an Ar gas atmosphere containing 35 ppm by volume of hydrogen and a heating temperature of 750 °C were used.

### (Comparative Example 4)

After producing the target material and the backing plate in the same method as that of Example 1, the target material and the backing plate were thermocompression-bonded by diffusion bonding in the same method as that of Example 1, with the exception that an Ar gas atmosphere containing 33 ppm by volume of hydrogen and a heating temperature of 650 °C were used.

### (Comparative Example 5)

After producing the target material and the backing plate in the same method as that of Example 1, the target material and the backing plate were thermocompression-bonded by diffusion bonding in the same method as that of Example 1, with the exception that an Ar gas atmosphere containing 35 ppm by volume of hydrogen and a heating temperature of 500 °C were used.

**[Table 1]**

| No. | Hydrogen Concentration in Ar Gas (ppm) | Hydrogen Content in Ta Target (ppm) | | | | Diffusion Bonding Temperature (°C) | Variation in Resputtering Rate (Å/sec) (Life 15kWhr-250kWhr) | Ta/CuZn Tensile Strength (kgf/mm²) | Hydrogen Content SIMS H/Ta Secondary Ion intensity Ratio in Ta Film |
|---|---|---|---|---|---|---|---|---|---|
| | | Surface | Center | Average | Difference | | | | |
| Example 1 | 4 | 7 | 7 | 7 | 0 | 800.0 | 0.6 | 27.5 | 2964.6 |
| Example 2 | 5 | 6 | 5 | 5.5 | 1 | 800.0 | 0.5 | 25.4 | 2826.9 |
| Example 3 | 5 | 5 | 5 | 5 | 0 | 750.0 | 0.4 | 26.1 | 2875.2 |
| Example 4 | 4 | 4 | 3 | 3.5 | 1 | 750.0 | 0.3 | 26.8 | 2875.2 |
| Example 5 | 4 | 3 | 2 | 2.5 | 1 | 650.0 | 0.2 | 20.5 | 2529.4 |
| Example 6 | 5 | 1 | 1 | 1 | 0 | 650.0 | 0.1 | 24.7 | 2438.1 |
| Example 7 | 5 | 1 | 1 | 1 | 0 | 600.0 | 0.1 | 20.1 | 2256.4 |
| Comparative Example 1 | 4 | 1 | 1 | 1 | 0 | 500.0 | 0.1 | 8.2 | 2247.2 |
| Comparative Example 2 | 30 | 10 | 12 | 11 | 2 | 800.0 | 1.5 | 26.4 | 6921.3 |
| Comparative Example 3 | 35 | 15 | 13 | 14 | 2 | 750.0 | 0.9 | 26.8 | 6022.3 |
| Comparative Example 4 | 33 | 12 | 14 | 13 | 2 | 650.0 | 0.8 | 27.4 | 4528.4 |
| Comparative Example 5 | 35 | 4 | 5 | 4.5 | 1 | 500.0 | 0.2 | 7.9 | 3215.6 |

For the joined body of the target material and the backing plate in each of Examples 1 to 7 and Comparative Examples 1 to 5, the variation in the resputtering rate and tensile strength between the target material and the backing plate were measured by the method as described above.

Further, using the joined body of the target material and the backing plate of each of Examples 1 to 7 and Comparative Examples 1 to 5, sputtering was carried out with a magnetron sputtering apparatus (Endura) from Applied Materials, under conditions of power supply of DC, a power of 25 kW, a wafer bias of 400 W and a deposition time of 25 sec to form a Ta film on the substrate. The hydrogen content SIMS analysis intensity ratio of the Ta film was measured according to the method as described above.

As shown in Table 1, in Examples 1 to 7 where the heating temperature during the joining of the target material and the backing plate was 600 °C to 800 °C and the hydrogen concentration in the inert gas atmosphere was 5 ppm by volume or less, the tensile strength between the target material and the backing plate was 196.133 MPa (20kgf/ mm²) or more, and the average hydrogen content in the target material was 7 ppm by volume or less. Also, the hydrogen content SIMS analysis intensity ratio in the Ta film was reduced, thereby providing a high-quality Ta thin film with small film stress.

In Comparative Example 1, the tensile strength between the target material and the backing plate was reduced due to the lower heating temperature during joining. In Comparative Examples 2 to 4, the average hydrogen content in the target material was increased due to the higher hydrogen concentration in the inert gas atmosphere.

In Comparative Example 5, the hydrogen concentration in the inert gas atmosphere was higher, but an increase in the average hydrogen content in the target material was suppressed by lowering the heating temperature during joining. However, since the heating temperature was lower, the tensile strength between the target material and the backing plate was lower.

## Claims

1. A joined body of a target material and a backing plate, the joined body comprising: a target material containing Ta; and a backing plate joined to the target material,
wherein a tensile strength between the target material and the backing plate is 196.133 MPa (20kgf/mm²) or more, and the target material joined to the backing plate has an average hydrogen content of 7 ppm by volume or less.

2. The joined body of the target material and the backing plate according to claim 1, wherein a difference between a hydrogen content at a target surface position of the target material and a hydrogen content at a central position in a thickness direction of the target material is 2 ppm by volume or less.

3. The joined body of the target material and the backing plate according to claim 1 or 2, wherein a Ta content in the target material is 99.99% by mass or more.

4. The joined body of the target material and the backing plate according to any one of claims 1 to 3, wherein the backing plate contains Cu and Zn.

5. The joined body of the target material and the backing plate according to claim 4, wherein a Cu content in the backing plate is from 60% by mass to 70% by mass, and a Zn content is from 30% by mass to 40% by mass.

6. A method for producing a joined body of a target material and a backing plate, the method comprising the steps of:
preparing each of a target material containing Ta and a backing plate; and
joining the target material to the backing plate by overlapping the target material and the backing plate with each other and pressing them while heating them in an inert gas atmosphere,
wherein in the step of joining the target material to the backing plate, a hydrogen concentration in the inert gas atmosphere is 5 ppm by volume or less, and the target material and the backing plate overlapped with each other are heated at a temperature of from 600 °C to 800 °C.

7. The method according to claim 6, wherein in the step of joining the target material to the backing plate, the target material and the backing plate overlapped with each other are pressed while being heated for 1 to 5 hours.

## Patentansprüche

1. Verbundkörper aus einem Zielmaterial und einer Trägerplatte, wobei der Verbundkörper Folgendes umfasst: ein Ta-hältiges Zielmaterial; und eine Trägerplatte, die mit dem Zielmaterial verbunden ist,
wobei eine Zugfestigkeit zwischen dem Zielmaterial und der Trägerplatte 196,133 MPa (20 kgf/mm²) oder mehr beträgt und das mit der Trägerplatte verbundene Zielmaterial einen mittleren Wasserstoffgehalt von 7 Vol.-ppm oder weniger aufweist.

2. Verbundkörper aus dem Zielmaterial und der Trägerplatte nach Anspruch 1, wobei eine Differenz zwischen dem Wasserstoffgehalt an einer Zieloberflächenposition des Zielmaterials und dem Wasserstoffgehalt an einer Mittelposition in einer Dickenrichtung des Zielmaterials 2 Vol.-ppm oder weniger beträgt.

3. Verbundkörper aus dem Zielmaterial und der Trägerplatte nach Anspruch 1 oder 2, wobei der Ta-Gehalt in dem Zielmaterial 99,99 Massen-% oder mehr beträgt.

4. Verbundkörper aus dem Zielmaterial und der Trägerplatte nach einem der Ansprüche 1 bis 3, wobei die Trägerplatte Cu und Zn enthält.

5. Verbundkörper aus dem Zielmaterial und der Trägerplatte nach Anspruch 4, wobei der Cu-Gehalt in der Trägerplatte 60 Massen-% bis 70 Massen-% und der Zn-Gehalt 30 Massen-% bis 40 Massen-% beträgt.

6. Verfahren zur Erzeugung eines Verbundkörpers aus einem Zielmaterial und einer Trägerplatte, wobei das Verfahren die folgenden Schritte umfasst:
das jeweilige Herstellen eines Ta-hältigen Zielmaterials und einer Trägerplatte; und
das Verbinden des Zielmaterials mit der Trägerplatte durch gegenseitiges Überlappen des Zielmaterials und der Trägerplatte und Pressen der beiden unter Erhitzen unter Inertgasatmosphäre,
wobei in dem Schritt des Verbindens des Zielmaterials mit der Trägerplatte die Wasserstoffkonzentration in der Inertgasatmosphäre 5 Vol.-ppm oder weniger beträgt und das gegenseitig mit der Trägerplatte überlappte Zielmaterial bei einer Temperatur von 600 °C bis 800 °C erhitzt wird.

7. Verfahren nach Anspruch 6, wobei in dem Schritt des Verbindens des Zielmaterials mit der Trägerplatte das gegenseitig mit der Trägerplatte überlappte Zielmaterial 1 bis 5 Stunden lang unter Erhitzen gepresst wird.

## Revendications

1. Corps assemblé d'un matériau cible et d'une plaque de support, le corps assemblé comprenant :
un matériau cible contenant du Ta ; et une plaque de support assemblée au matériau cible,
dans lequel une résistance à la traction entre le matériau cible et la plaque de support est de 196,133 MPa (20 kgf/mm²) ou plus, et le matériau cible assemblé à la plaque de support présente une teneur moyenne en hydrogène de 7 ppm en volume ou moins.

2. Corps assemblé du matériau cible et de la plaque de support selon la revendication 1, dans lequel une différence entre une teneur en hydrogène au niveau d'une position de surface cible du matériau cible et une teneur en hydrogène au niveau d'une position centrale dans une direction d'épaisseur du matériau cible est de 2 ppm en volume ou moins.

3. Corps assemblé du matériau cible et de la plaque de support selon la revendication 1 ou 2, dans lequel une teneur en Ta dans le matériau cible est de 99,99 % en masse ou plus.

4. Corps assemblé du matériau cible et de la plaque de support selon l'une quelconque des revendications 1 à 3, dans lequel la plaque de support contient du Cu et du Zn.

5. Corps assemblé du matériau cible et de la plaque de support selon la revendication 4, dans lequel une teneur en Cu dans la plaque de support est de 60 % en masse à 70 % en masse, et une teneur en Zn est de 30 % en masse à 40 % en masse.

6. Procédé de production d'un corps assemblé d'un matériau cible et d'une plaque de support, le procédé comprenant les étapes consistant à :
préparer chacun d'un matériau cible contenant du Ta et d'une plaque de support ; et
assembler le matériau cible à la plaque de support en mettant en chevauchement le matériau cible et la plaque de support l'un avec l'autre et en les comprimant tout en les chauffant dans une atmosphère de gaz inerte,
dans lequel, dans l'étape d'assemblage du matériau cible à la plaque de support, une concentration en hydrogène dans l'atmosphère de gaz inerte est de 5 ppm en volume ou moins, et le matériau cible et la plaque de support mis en chevauchement l'un avec l'autre sont chauffés à une température de 600°C à 800°C.

7. Procédé selon la revendication 6, dans lequel dans l'étape consistant à assembler le matériau cible à la plaque de support, le matériau cible et la plaque de support mis en chevauchement l'un avec l'autre sont comprimés tout en étant chauffés pendant 1 à 5 heures.
